# EUROPEAN PATENT APPLICATION

(11) **EP 4 822 987 A1**
(43) Date of publication of application: **14.10.2026**
(21) Application number: 26169650.4
(22) Date of filing: 31.03.2026
(51) Int. Cl.: H03F 1/52, H03F 3/45

(54) **SELF-PROTECTED HIGH-TRANSCONDUCTANCE INPUT STAGE FOR COMPARATORS AND AMPLIFIERS**

(30) Priority: 07.04.2025 US 202519172169
(71) Applicant: Analog Devices International Unlimited Company, Limerick (IE)
(72) Inventor: BERKOL, Gonenc, Co. Limerick (IE); AKSIN, Devrim Yilmaz, Wilmington, 01887 (US); HAMILTON, Brian D., Wilmington, 01887 (US)
(74) Representative: Wallin, Nicholas James

(57) **Abstract**

A low input-capacitance input stage, with wide common-mode and differential input voltage compliance, for a high voltage comparator or amplifier includes a first input transistor configured to receive a first portion of a differential input signal and provide a first portion of an output signal, and a second input transistor configured to receive a second portion of the differential input signal and provide a second portion of the output signal. The amplifier can include a degeneration stage. The degeneration stage can include first and second degeneration cascode circuits coupled in series. In an example, the first and second portions of the output signals can be provided using respective protection devices that are provided in cascode configuration with the first and second input transistors, respectively.

## Description

### BACKGROUND

A transconductance circuit (also referred to as a "transconductor" or a "voltage-to-current converter") is a circuit that generates an output current corresponding to, or proportional to, an input voltage. Transconductance circuits may be used in many modern electronic systems in a wide range of markets, such as including industrial, military, automotive, and automatic testing (e.g., pin electronics) environments. In an example, one or more transconductance circuits may be used in an amplifier or a comparator circuit.

### BRIEF SUMMARY

The present inventors have recognized that a problem to be solved includes providing an input stage for a comparator or amplifier, where the input stage has high transconductance, large differential voltage and common mode voltage compliance and reliability, low input capacitance, and high bandwidth characteristics. An input stage with relatively low input capacitance characteristics can be driven by preceding stages more easily than efficiently. The input stage can optionally be used as a direct interface for a comparator, an amplifier, or other component such as for automated test equipment.

In an example, a solution can include or use a system comprising a transconductance circuit with degeneration transistors. In some examples, a transconductance circuit with degeneration transistors can be used as a transconductance input stage of an amplification stage, where the transconductance input stage is configured to convert an input voltage signal to an output current signal. In some examples, the amplification stage may further include a load stage, configured to convert the input stage output current back to an output voltage. One or more of such amplification stages may be included in a device such as an amplifier or a comparator.

In an example, an input stage circuit can include a first input transistor (M₁) configured to receive a first portion of a differential input signal at a first gate terminal (V_{IP}) and provide a first portion of an output signal at a first drain terminal (I_{OP}) of the first input transistor, and the input stage circuit can include a second input transistor (M₂) configured to receive a second portion of the differential input signal at a second gate terminal (V_{IM}) and provide a second portion of the output signal at a second drain terminal (I_{OM}) of the second input transistor. In an example, respective protection devices can be provided as cascode devices together with the first and second input transistors, and the output signals can be provided to the load via the protection devices. The input stage circuit can further include a degeneration stage circuit with first and second degeneration transistors (M_{D1}, M_{D2}) and corresponding respective protection devices (M_{DP}, M_{DN}). A bias generator circuit can be configured to provide respective bias signals to gate terminals of the various protection devices. The degeneration stage circuit can be configured to control an impedance of a signal path that couples source terminals of the first and second input transistors.

In an example, a method for controlling gain and bandwidth characteristics of an input stage circuit can include receiving first and second input stage input signals at respective first and second input nodes of respective first and second input transistors (e.g., M₁ and M₂), and receiving the first and second input stage input signals at respective first and second input nodes of respective first and second degeneration transistors (e.g., M_{D1} and M_{D2}). The method can include, using a first bias circuit, providing a first bias signal to a gate terminal of a first protection device (M_{CP}) and, using a second bias circuit, providing a second bias signal to a gate terminal of a second protection device (M_{CN}). In an example, in response to receiving the input signals at the first and second degeneration transistors, the method can include adjusting an impedance characteristic of a signal path coupling the first and second input transistors. The method can further include providing a first input stage output signal using a first output terminal of the first protection device (M_{CP}), wherein the first protection device is provided in cascode with the first input transistor (M₁) and providing a second input stage output signal using a second output terminal of the second protection device (M_{CN}), wherein the second protection device is provided in cascode with the second input transistor (M₂).

This summary is not intended to provide an exclusive or exhaustive explanation of the invention. The detailed description is included to provide further information about the present patent application.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1 illustrates generally an example of a first test system that includes a pin driver.
FIG. 2 illustrates generally an example of a first transconductance circuit.
FIG. 3 illustrates generally an example of a second transconductance circuit.
FIG. 4A illustrates generally a first example transconductance stage of an input stage circuit.
FIG. 4B illustrates generally a second example transconductance stage of an input stage circuit.
FIG. 5 illustrates generally an example PMOS transconductance stage of an input stage circuit.
FIG. 6 illustrates generally a third example transconductance stage of an input stage circuit.
FIG. 7 illustrates generally an example of a method for controlling gain and bandwidth characteristics of an input stage circuit.

### DETAILED DESCRIPTION

High-voltage comparators or amplifiers are key components in many modern electronic systems. Such amplifiers can be used in industrial, medical, automotive, and automatic testing equipment (ATE) devices, among others. The particular end application can have various requirements, such as for particular voltage compliance levels, and therefore various amplifier systems are needed, such as systems that can operate over a wide input/output voltage range, including in a range that may exceed a breakdown voltage of individual devices that comprise such amplifier systems.

In an example, ATE applications use high-voltage amplifiers to provide a time management unit (TMU) and/or a high-voltage driver (HVD), where wide input/output voltage range (e.g., hundreds of volts), relatively high-speed (e.g., tens of megahertz) and low-power consumption (e.g., in a milliwatt range, to enable high volume device testing) are three key performance metrics. A source impedance, e.g., of a preceding stage that drives the amplifier or comparator can affect the bandwidth characteristics of the system. In applications where a source impedance is high, subsequent amplifier stages can be configured to have a characteristically low input capacitance to ensure adequate bandwidth performance. Additionally, when an amplifier is used in a feedback configuration, e.g., to maximize bandwidth and minimize power consumption, a low-capacitance input stage can be desired.

In an example, laterally diffused MOSFET (LDMOS) devices can include high-voltage devices that can be used in high voltage amplifier input stages. Such devices can have a characteristically high blocking voltage due to a diffused p-type channel region in a low-doped n-type drain region. Due to the relatively large size of such devices, the devices can have characteristically higher parasitic capacitance values compared to that of non-LDMOS devices or other low-voltage devices.

The present inventors have recognized that a problem to be solved includes providing an input stage, or transconductance stage, that has low input capacitance, large differential and common-mode voltage compliance, and high bandwidth characteristics. The problem includes providing a differential input stage that has high tolerance for large common mode (CM) and differential mode (DM) input voltages. The present inventors have recognized that an issue with a standard differential pair input stage, such as can use DMOS devices (e.g., double-diffused MOSFET devices or laterally diffused MOSFET devices), is that while a differential pair can handle a large CM range, such an input stage can be limited by a relatively low (e.g., 5V) Vgs (gate-source voltage) limit, beyond which the device gate oxide can fail and device damage can occur. This limitation means that while an LDMOS device can tolerate high Vds (drain-source voltage) and Vdg (drain-gate voltage), the Vgs tolerance is low, resulting in a circuit that can handle high CM voltages but has small DM voltage tolerance. Furthermore, the present inventors have recognized that using high-voltage diodes at the tail node (e.g., provided in series with the sources of the LDMOS devices that comprise a differential pair) to improve DM tolerance is not always available because not all processes offer high-voltage diodes. Furthermore, even if high-voltage diodes are available, they can have characteristically slow reverse recovery time characteristics, which can inhibit their use in high speed circuits such as comparators.

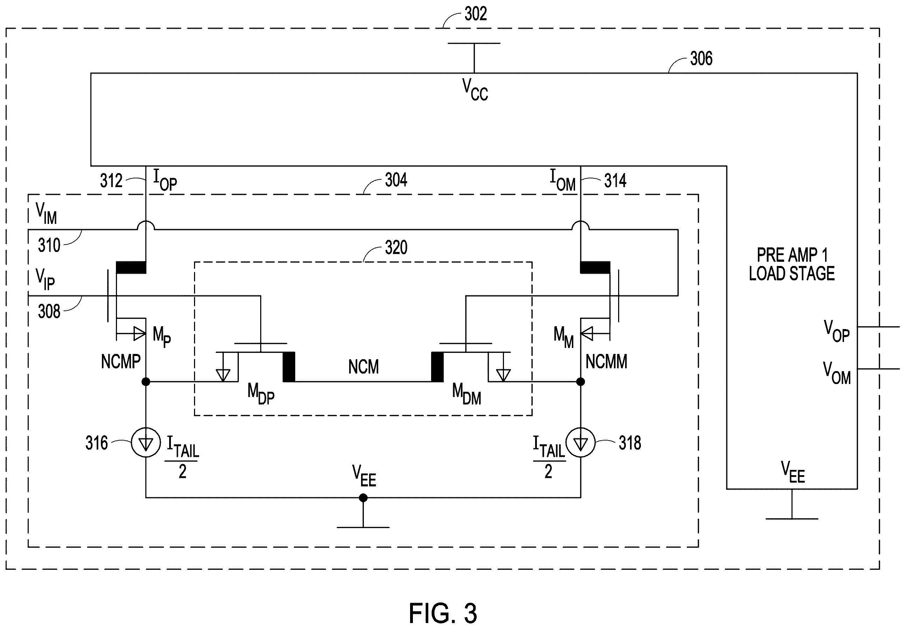

Other solutions that use transistors at the tail node (e.g., in series with the differential pair device sources; see FIG. 3) are called self-protected input stages. The circuit in FIG. 3, for example, can be used to achieve high CM and DM voltage compliance, however, it can exhibit relatively poor performance in terms of gain, bandwidth, and power consumption, and can have relatively large input capacitance. Specifically, in a particular transistor-based approach, physically large transistors are used to achieve high gain, which in turn capacitively loads the amplifier inputs and reduces the bandwidth of the input stage. Achieving high bandwidth generally requires physically small transistors which may need protection when used in a high-voltage environment.

In an example, ATE applications require performance specifications that can include wide input/output operating voltage range (e.g., -60V to 160V), high-speed (e.g., up to or exceeding 100MHz) and low-power consumption (e.g., a few hundred milliwatts to enable high volume device testing). An ideal input stage can therefore withstand large differential voltage swings without extra peripheral circuitry, provide efficient transconductance for a given bias current to optimize power efficiency, and provide a low input capacitance to enable use with high speed signals.

The present inventors have recognized that a solution to these problems and limitations can include or use low voltage devices (e.g., DMOS, bipolar, or MOSFET, etc.) to provide a differential pair for an input stage circuit. Respective LDMOS devices can be provided for each of the low voltage devices of the differential pair to provide respective cascode circuits. The input stage circuit can include or use other low voltage devices as degeneration transistors. Other respective LDMOS devices can be provided as cascode devices with respect to the degeneration transistors. By controlling operation of these transistors, input stage CM and DM voltage tolerance is improved, and high gain and high bandwidth can be achieved when a differential pair of low-voltage devices is used. Due to the low-voltage devices applied as the input differential pair, reduced input capacitance can be achieved relative to other approaches. In an example, the solution can include or use high-voltage diodes for isolation in the degeneration path. That is, the solution can optionally use diodes instead of degeneration transistors. The diode-based solution can offer higher overall transconductance, however, its implementation may depend on availability of diodes with adequate reverse recovery characteristics, which may present challenges in some fabrication processes.

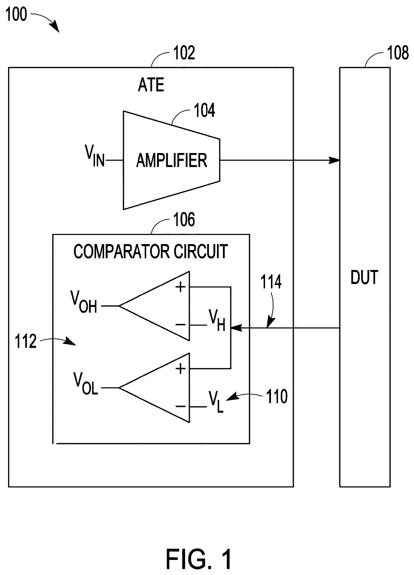

FIG. 1 illustrates generally a first example test system 100 showing a test system 102 topology that can include one or more drivers coupled to a DUT 108, and a comparator circuit 106 configured to receive signals from the DUT 108 via a DUT node 114. The test system 102 can comprise a portion of an automated test equipment (ATE) system.

In an example, the test system 102 includes a first driver 104. The first driver 104 can be a class A driver, a class AB driver, or other type of driver. The first driver 104 can provide test signals to the DUT 108 in response to an input signal or control signal V_{IN}. In an example, the first driver 104 can be configured to produce transitions at the DUT node 114 using a relatively large current switch stage that can be coupled directly to the DUT node 114. A current switching stage in the first driver 104 can alternately switch current into and out of the DUT node 114.

FIG. 1 includes the comparator circuit 106. The comparator circuit 106 can include a single-stage or multiple-stage comparator that is configured to receive a signal from the DUT 108, such as via the DUT node 114. The comparator circuit 106 can compare the received signals to comparator reference signals 110 (e.g., V_{H}, V_{L}) and, in response, provide a differential comparator output signal 112 (e.g., V_{OH}, V_{OL}). Timing characteristics of the differential comparator output signal 112 can be used to evaluate performance of the DUT 108.

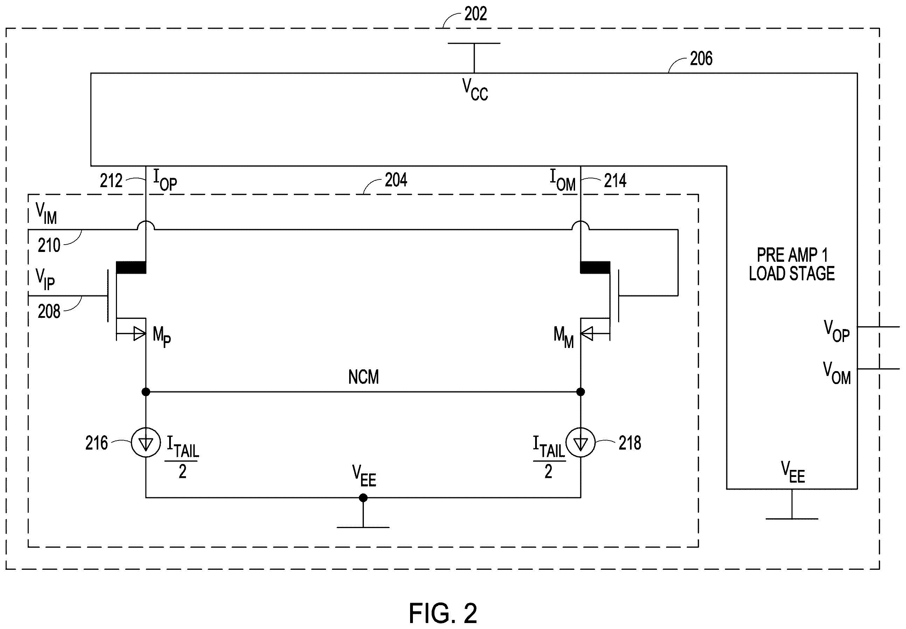

FIG. 2 illustrates generally an example of a first amplification stage 202. The first amplification stage 202 can include a first transconductance circuit 204 with multiple follower circuits. In the example of FIG. 2, the first transconductance circuit 204 includes a pair of source-follower circuits arranged as a differential pair. In an example, the first amplification stage 202 comprises a comparator or an amplifier, such as can include an input stage of a comparator. The first amplification stage 202 can be a first preamplifier stage and may be followed up by one or more other gain stages. In the example of FIG. 2, the first amplification stage 202 can include a load circuit 206, which in turn can provide an output to a subsequent gain stage or output stage.

The example of FIG. 2 shows a first input transistor M_{P} comprising a first portion of the first transconductance circuit 204 and a second input transistor M_{M} comprising a second portion of the first transconductance circuit 204. In an example, the input transistors M_{P} and M_{M} comprise a differential pair circuit. Each of the input transistors M_{P} and M_{M} can include a respective high-voltage transistor (e.g., an LDMOS transistor). A common-mode voltage range of the differential pair can be equal to the LDMOS drain-source (DS) breakdown voltage (BV), or BVDS (e.g., 24 V, 80 V, 120 V, or more). The differential input voltage range, however, can be approximately equal to a gate-to-source breakdown voltage plus a gate-to-source voltage, or Vgs (e.g., 6 V).

In the first transconductance circuit 204, one terminal of the first input transistor M_{P} (e.g., the gate terminal of the transistor M_{P}) is coupled to a first input 208 and the first input transistor M_{P} receives a first input voltage V_{IP}. One terminal of the second input transistor M_{M} (e.g., the gate terminal of the transistor M_{M}) is coupled to a second input 210 and the second input transistor M_{M} receives a second input voltage V_{IM}. A second terminal of the first input transistor M_{P} (e.g., the drain terminal of the transistor M_{P}) is coupled to a first output 212 to provide a first output current I_{OP}, and a second terminal of the second input transistor M_{M} (e.g., the drain terminal of the transistor M_{M}) is coupled to a second output 214 to provide a second output current I_{OM}. A third terminal of the first input transistor M_{P} (e.g., the source terminal of the transistor M_{P}) is coupled to a third terminal of the second input transistor M_{M} (e.g., the source terminal of the transistor M_{M}), e.g., via an intermediate node NCM. For each of transistors M_{P} and M_{M}, the source terminal of the transistor can be coupled to the back gate terminal of the transistor. Typically, source and body terminals of LDMOS transistors can be tied together to ensure device reliability.

In an example, the first transconductance circuit 204 can include a tail current source, such as a first current source 216 and a second current source 218. The first current source 216 can be coupled to the source terminal of the first input transistor M_{P}, and the second current source 218 can be coupled to the source terminal of the second input transistor M_{M}. Together, the first current source 216 and the second current source 218 provide a total tail current I_{Tail} for the differential pair of the input transistors M_{P} and M_{M} of the first transconductance circuit 204. In an example, each of the first current source 216 and the second current source 218 provides a tail current I_{Tail}/2.

In some examples, the first transconductance circuit 204 comprises a portion of a comparator circuit. In this case, V_{IP} and V_{IM} can be the inputs to the comparator. The inputs can be provided or driven by an outside source, such as a DUT. The first transconductance circuit 204 can thus be configured to evaluate a difference between the voltage levels of the inputs V_{IP} and V_{IM} and generate an output current that represents whether the difference is positive or negative (e.g., to generate a logic 1 or logic 0 output indicative of whether the difference between the voltage levels of the inputs V_{IP} and V_{IM} is positive or negative). For example, when the difference I_{OP}-I_{OM} is positive then the difference V_{IP}-V_{IM} is positive, and when the difference I_{OP}-I_{OM} is negative then the difference V_{IP}-V_{IM} is negative. A magnitude of the difference between I_{OP} and I_{OM} can be a function of the magnitude difference between V_{IP} and V_{IM}.

In an example, the first transconductance circuit 204 comprises an amplifier, such as can be used in a feedback circuit. Such an example of the first transconductance circuit 204 can be configured to make the inputs V_{IP} and V_{IM} substantially equal by changing the outputs I_{OP} and I_{OM}, which outputs may then be coupled to the amplifier input through a feedback path.

A problem with the first transconductance circuit 204 may arise because the voltage at the NCM node is set by the one of the input transistors M_{P} and M_{M} that has the largest input voltage at its gate. When the differential pair of the input transistors M_{P} and M_{M} completely switches the tail current I_{Tail} to a particular one of the first output 212 and the second output 214, the turned-off input transistor (i.e., the one of the input transistors M_{P} and M_{M} that has the lowest input signal at its gate terminal) can experience a gate breakdown at its source terminal boundary. For example, when the first transconductance circuit 204 is used in a comparator (e.g., a high-voltage comparator), the difference between V_{IP} and V_{IM} can exceed the gate oxide reliability voltage rating of the input transistors M_{P} and M_{M}. When the first transconductance circuit 204 is used in an amplifier, and if the amplifier input signal range is larger than the breakdown ratings of the input transistors M_{P} and M_{M}, then the amplifier may have the same reliability problem as a high-voltage comparator. During steady-state, such as when the amplifier settles to its final output level or waveform, the two inputs V_{IP} and V_{IM} would be substantially equal and would not have a reliability problem, but the inputs V_{IP} and V_{IM} can be significantly different at the beginning of the settling, which can create reliability issues for the amplifier. Hence, the differential pair-based first transconductance circuit 204 can be insufficient or unreliable for high-voltage applications where the differential input voltage range exceeds a limit for device gate oxide reliability.

FIG. 3 illustrates generally an example of a second transconductance circuit 304 with a differential pair included in a second amplification stage 302. In an example, the second amplification stage 302 comprises a comparator or an amplifier, such as can comprise an input stage of a comparator. The second amplification stage 302 can be a first preamplifier stage and can be followed by one or more other gain stages.

The example of FIG. 3 shows the differential pair of input transistors M_{P} and M_{M}, such as comprising respective follower circuits, and each of the input transistors can include a high-voltage transistor (e.g., an LDMOS transistor). A common-mode voltage range of the input differential pair is equal to the LDMOS BVDS, e.g., 24 V or more. The architecture shown in FIG. 3 is symmetrical with respect to the input terminals, and it can process single-ended or differential input signals. The second transconductance circuit 304 can operate reliably up to the BVDS voltage of the LDMOS devices, for example, without additional isolation diodes or other circuitry to realize additional headroom.

In the second transconductance circuit 304, as similarly provided for the first transconductance circuit 204, one terminal of the first input transistor M_{P} (e.g., the gate terminal of the transistor M_{P}) is coupled to the first input 308 and the first input transistor M_{P} receives a first input voltage V_{IP}. One terminal of the second input transistor M_{M} (e.g., the gate terminal of the transistor M_{M}) is coupled to the second input 310 and the second input transistor M_{M} receives a second input voltage V_{IM}. A second terminal of the first input transistor M_{P} (e.g., the drain terminal of the transistor M_{P}) is coupled to the first output 312 to provide a first output current I_{OP}, and a second terminal of the second input transistor M_{M} (e.g., the drain terminal of the transistor M_{M}) is coupled to the second output 314 to provide a second output current I_{OM}.

In contrast to the example of the first transconductance circuit 204 from FIG. 2, the second transconductance circuit 304 in FIG. 3 includes a first degeneration stage circuit 320. The first degeneration stage circuit 320 is configured to provide an adjustable-impedance signal path between the first input transistor M_{P} and the second input transistor M_{M}. The first degeneration stage circuit 320 includes a first degeneration transistor M_{DP} and a second degeneration transistor M_{DM}. The first and second degeneration transistors M_{DP} and M_{DM} can function as nonlinear degeneration resistors. That is, each of transistors M_{DP} and M_{DM} operates as a resistor between their drain and source terminals, where the value of the drain-source resistance is based on the voltage difference between the first and second input voltages. In some examples, the variation of the drain-source resistance may be a nonlinear function of the voltage difference between the first and second voltage inputs. Since transistors M_{DP} and M_{DM} operate like resistors, they are degenerating the input differential pair formed by the first and second input transistors, M_{P} and M_{M}. Consequently, transistors M_{DP} and M_{DM} are referred to herein as "degeneration transistors." Due to the relatively large LDMOS devices being coupled to the input nodes V_{IP} and V_{M}, the second transconductance circuit 304 can have characteristically large input capacitance.

In the example of FIG. 3, a third terminal of the first input transistor M_{P} (e.g., the source terminal of the transistor M_{P}) is coupled to a third terminal of the first degeneration transistor M_{DP} (e.g., the source terminal of the first degeneration transistor M_{DP}, which source terminal is coupled to the back gate terminal of the first degeneration transistor M_{DP}). A third terminal of the second input transistor M_{M} (e.g., the source terminal of the transistor M_{M}) is coupled to a third terminal of the second degeneration transistor M_{DM} (e.g., the source terminal of the second degeneration transistor M_{DM}, which source terminal is coupled to the back gate terminal of the second degeneration transistor M_{DM}). The second terminal of the first degeneration transistor M_{DP} (e.g., the drain terminal of the first degeneration transistor M_{DP}) is coupled to the second terminal of the second degeneration transistor M_{DM} (e.g., the drain terminal of the second degeneration transistor M_{DM}) at the node NCM. The first terminal of the first degeneration transistor M_{DP} (e.g., the gate terminal of the first degeneration transistor M_{DP}) is coupled to the first input 308 where the first degeneration transistor M_{DP} receives the first input voltage V_{IP}, while the first terminal of the second degeneration transistor M_{DM} (e.g., the gate terminal of the degeneration transistor M_{DM}) is coupled to the second input 310 and the second degeneration transistor M_{DM} receives the second input voltage V_{IM}.

In operation of the second transconductance circuit 304, each of the first input transistor M_{P} and the second input transistor M_{M} can operate in a saturation region. The first degeneration transistor M_{DP} and the second degeneration transistor M_{DM} may be configured to operate either in a linear (triode) region or in a saturation region, and when one of the degeneration transistors M_{DP} and M_{DM} enters the saturation region, the other degeneration transistor can continue to operate in the linear region.

During operation of the second transconductance circuit 304, a degeneration resistance provided at the source terminal of the first degeneration transistor M_{DP} (e.g., the node NCMP shown in FIG. 3) and a degeneration resistance at the source terminal of the second degeneration transistor M_{DM} (e.g., the node NCMM) may be symmetric with respect to the input signal difference between V_{IP} and V_{IM}, or ΔV_{I}. That is, the resistance between the nodes NCMP and NCMM can change in accordance with changes in the applied input signal difference V_{IP}-V_{IM}. The value of this resistance can correspondingly change a value of the transconductance G_{M}, where the change is symmetric in that G_{M}(V_{IP}-V_{IM})=G_{M}(V_{IM}-V_{IP}). Hence, the second transconductance circuit 304 can produce the same output currents I_{OP} and I_{OM} if a voltage difference of 100 mV or a voltage difference of -100 mV is applied at the inputs V_{IP} and V_{IM}.

In an example, a total degeneration resistance between the nodes NCMP and NCMM may be smallest when the first input voltage V_{IP} is substantially equal to the second input voltage V_{IM}. Furthermore, the equivalent resistance between the source terminal of the first degeneration transistor M_{DP} and the source terminal of the second degeneration transistor M_{DM} may increase as an absolute value (or magnitude) of a difference between the input voltages V_{IP} and V_{IM} increases. When the degeneration transistor whose gate terminal is coupled to the lowest input voltage (which could be either the first or second degeneration transistor M_{DP} or M_{DM}) enters into the saturation region, the positive and negative signal-handling portions of the second transconductance circuit 304 become effectively isolated from each other. Hence, the example input stage can tolerate a wide range of input differential voltages without requiring other protection devices.

Turning to the aspect ratios of various transistors included in the transconductance circuit, an aspect ratio (Aₓ) of a FET refers to a ratio of a channel width (wₓ) to a channel length (lₓ) of the FET. In some embodiments of a transconductance circuit, a ratio of an aspect ratio of the first degeneration transistor M_{DP} to an aspect ratio of the first input transistor M_{P} may be substantially equal to a ratio of an aspect ratio of the second degeneration transistor M_{DM} to an aspect ratio of the second input transistor M_{M}. In some embodiments, the aspect ratio of the first input transistor M_{P} may be substantially equal to the aspect ratio of the second input transistor M_{M}, or, equivalently, the aspect ratio of the first degeneration transistor M_{DP} may be substantially equal to the aspect ratio of the second degeneration transistor M_{DM}. For example, the aspect ratio of each of the first and second input transistors M_{P}, M_{M} may be about 1, while the aspect ratio of each of the first and second degeneration transistors M_{DP}, M_{DM} may be about N, where N is any positive real number. However, in other embodiments, these aspect ratios may be different, as long as the ratio of the aspect ratios of the first degeneration and input transistors M_{DP}, M_{P} is substantially equal to the ratio of the aspect ratios of the second degeneration and input transistors M_{DM}, M_{M}.

In the example of FIG. 3, the first and second degeneration transistors M_{DP} and M_{DM} reduce the equivalent transconductance G_{M} of the differential pair of the first and second input transistors M_{P} and M_{M}. It can be shown that the equivalent transconductance G_{M} at ΔV_{I}=0 may be reduced by N/(1+N). Hence, the equivalent transconductance G_{M} may drop to 80% of its value compared to the zero-degeneration case at the same power level when N=4.

When one of the first and second degeneration transistors M_{DP} and M_{DM} enters the saturation region, the drain current of the corresponding input transistor reaches its minimum level and is substantially equal to I_{Tail}/2*(N+1). The remaining of the respective input side tail current may then be conveyed to the complementary half input side through the degeneration transistor operating in the saturation region. Under this condition, the ratio of the output currents can be substantially equal to 2N+1. If desired, these values can be arbitrarily set by properly choosing the ratio of the input and degeneration transistor aspect ratios, i.e., by choosing N.

In some examples, high small-signal gain and small input signal difference for total tail current switching may favor a relatively large N values, whereas reduced large signal overdrive and reduced NCMP/NCMM node capacitance-related delay variation may favor a relatively small N values. The exact value of N used for the transistors in the second transconductance circuit 304 can be determined, for example, using simulation. It can be shown that, in some implementations, when one of the first and second degeneration transistors M_{DP} and M_{DM} enters into the saturation region, the other degeneration transistor stays in the linear operation region if N is chosen larger than or equal to about 1.5. The large voltage drop between NCMP and NCMM nodes may appear mainly across the drain source terminal of the degeneration transistor operating in the saturation region.

The second transconductance circuit 304 is thus substantially symmetric with respect to the input terminals and, therefore, can process both single-ended and differential input signals. By including the first and second degeneration transistors M_{DP} and M_{DM}, the second transconductance circuit 304 can operate up to the BVDS of the transistors included therein without reliability problems and in absence of additional protection mechanisms.

The present inventors have recognized that while the second transconductance circuit 304 provides high common mode and differential mode voltage tolerance, it exhibits relatively low gain (transconductance) and low bandwidth. High gain, for example, generally requires use of physically large implementations (e.g., N>4) of the first and second degeneration transistors M_{DP} and M_{DM}, which in turn capacitively loads the first input 308 and the second input 310, respectively, and reduces bandwidth of the circuit. Conversely, high bandwidth generally requires use of physically small implementations of the first and second degeneration transistors M_{DP} and M_{DM}, which would reduce gain of the circuit. Thus, the circuit may not simultaneously achieve high gain and high bandwidth, which is undesirable for an ideal input stage.

The present inventors have recognized that a solution to these and other problems can include or use an input stage with physically small input devices to form the main differential pair of a transconductance circuit, and each of the input devices can be protected using a larger device in a cascode configuration. The input stage can include degeneration devices, and the degeneration devices can be physically small devices with corresponding larger protection devices in cascode. Bias control circuits can be provided to control operation of the larger protection devices and thereby the input stage circuit can more closely approximate behavior of an ideal input stage.

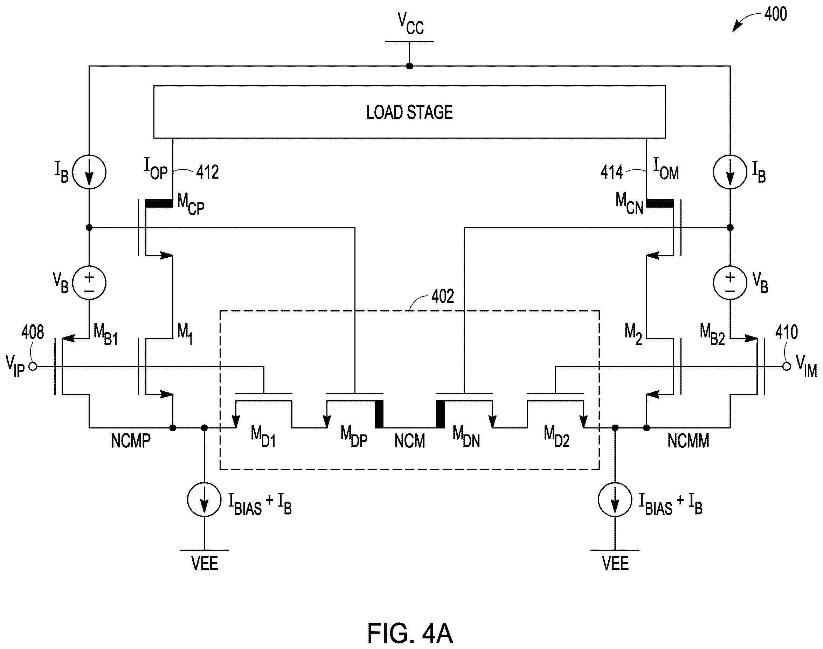

FIG. 4A illustrates generally a first example transconductance stage 400 with low-voltage input devices and high-voltage protection devices. The low-voltage input devices and high-voltage protection devices have different respective breakdown voltage characteristics. That is, the high-voltage devices can be configured for operation at relatively higher voltages than the low-voltage devices. The high-voltage devices can include, for example, laterally diffused metal-oxide semiconductor (LDMOS) transistor devices, and the low-voltage devices can include, for example, low-voltage core or thin-oxide MOS devices, for example provided using a bipolar or MOS-DMOS (BCD) based technology, or using thin-film transistor (TFT) devices. Any one or more of a particular high-voltage device or low-voltage device can include multiple instances of a transistor coupled in parallel to achieve a particular effective device size. In an example, the first example transconductance stage 400 comprises a comparator or amplifier, such as can comprise an input stage of a comparator.

The first example transconductance stage 400 is symmetrical with respect to the input terminals (e.g., a first input 408 and a second input 410) and can process single-ended or differential input signals. The first example transconductance stage 400 can include a second degeneration stage circuit 402 that controls an impedance between the source terminals of the low-voltage input devices (e.g., at nodes NCMP and NCMM).

The first example transconductance stage 400 can operate reliably up to the BVDS voltage of the high-voltage protection devices, for example, 24 V or more. In an example, the circuit does not include or use high breakdown voltage protection or isolation diodes.

The example of FIG. 4A shows a differential pair of low-voltage input transistors M₁ and M₂. The low-voltage input transistors can each comprise, for example, an oxide thin-film transistor (e.g., an oxide TFT) or complementary metal oxide transistor. In an example, the low-voltage devices include an active channel portion that is made from a thin layer of a metal oxide such as indium gallium zinc oxide (IGZO) or other material. Other devices can similarly be used. In an example, the low-voltage input transistors M₁ and M₂ are different from LDMOS devices.

In the first example transconductance stage 400, as similarly provided in the first transconductance circuit 204 and the second transconductance circuit 304, one terminal of the first input transistor M₁ (e.g., the gate terminal of the transistor M₁) is coupled to the first input 408 and the first input transistor M₁ receives a first input voltage V_{IP}. One terminal of the second input transistor M₂ (e.g., the gate terminal of the transistor M₂) is coupled to the second input 410 and the second input transistor M₂ receives a second input voltage V_{IM}. A second terminal of the first input transistor M₁ (e.g., the drain terminal of the transistor M₁) is coupled to the first output 412, via a first cascode device M_{CP}, to provide a first output current I_{OP}. A second terminal of the second input transistor M₂ (e.g., the drain terminal of the transistor M₂) is coupled to the second output 414, via a second cascode device M_{CN}, to provide a second output current I_{OM}. In an example, the first and second cascode devices M_{CP} and M_{CN} comprise respective LDMOS devices. The first and second cascode devices M_{CP} and M_{CN} are provided to protect the drain terminals of their corresponding respective low-voltage input devices M₁ and M₂ against drain to source breakdown when the input stage is subject to large differential input signals at the first input 408 and the second input 410.

The second degeneration stage circuit 402 of the first example transconductance stage 400 includes low-voltage degeneration devices M_{D1} and M_{D2}, and high-voltage degeneration devices M_{DP} and M_{DN}. In an example, the low-voltage degeneration devices M_{D1} and M_{D2} comprise respective low-voltage MOS devices, and the high-voltage degeneration devices M_{DP} and M_{DN} comprise respective LDMOS devices. Generally, the low-voltage degeneration devices M_{D1} and M_{D2} can be other than or different from LDMOS devices. The degeneration devices can be used together for high-voltage protection when a large differential signal is present at the first input 408 and the second input 410. In an example, the second degeneration stage circuit 402 includes first and second cascode circuits joined in series at node NCM. Each cascode circuit includes a low-voltage device and a high-voltage device. For example, the first cascode circuit can include the first low-voltage degeneration device M_{D1} and the first high-voltage degeneration device M_{DP}. The second cascode circuit can include the second low-voltage degeneration device M_{D2} and the second high-voltage degeneration device M_{DN}.

In an example, the first example transconductance stage 400 includes bias circuitry configured to bias the various high-voltage devices, such as the M_{CP}, M_{DP}, M_{CN}, and M_{DN} devices. The bias circuitry can be used to help ensure the low-voltage input transistors M₁ and M₂ operate in a saturation region. In an example, the bias circuitry can include a current source configured to provide a tail current or bias current, I_{BIAS}, for each leg of the differential circuit. The bias current, I_{BIAS}, can be a minimum current that flows through the input devices M₁ and M₂ and maintains the devices in the saturation region.

In an example, the first and second low-voltage input transistors M₁ and M₂ operate in the saturation region, while the transistors in the second degeneration stage circuit 402 (e.g., devices M_{D1}, M_{DP}, M_{D2}, and M_{DN}) operate either in the linear or saturation region and function as a nonlinear degeneration resistor between the differential input devices. When the degeneration transistor whose gate is connected to the lowest input voltage enters into the saturation region, the positive and negative halves of the circuit become effectively isolated from each other. Accordingly, the first example transconductance stage 400 is self-protected. In an example, the equivalent input stage transconductance of the first example transconductance stage 400 is N/(1+N), where N is the ratio of the aspect ratios between the low-voltage input transistors M₁ and M₂ and the low-voltage degeneration transistors M_{D1} and M_{D2}.

In an example, the bias circuitry for the first example transconductance stage 400 comprises a first bias circuit that can include a first PMOS device M_{B1}, such as a MOS device. The first PMOS device M_{B1} can be configured as a source follower to bias the high-voltage devices M_{CP} and M_{DP}. For example, the first PMOS device M_{B1} can include a gate terminal coupled to the first input 408, a drain terminal coupled to the source terminal of the first low-voltage device M₁ at node NCMP, and a source terminal coupled to the gate terminal of the first cascode device M_{CP}. In an example, the first bias circuit can include or use a voltage source V_{B} between the first PMOS device M_{B1} and the gate terminal of the first cascode device M_{CP}, or can include a current source I_{B} coupled to the gate terminal of the first cascode device M_{CP}. In an example, the voltage source V_{B} can be optional and can be implemented using, for example, a resistor or low-voltage diode. The current source I_{B} can be used to bias the first PMOS device M_{B1}.

In an example, the first example transconductance stage 400 includes a second bias circuit configured symmetrically with the first bias circuit. For example, the second bias circuit can include a second PMOS device M_{B2}, such as can comprise a MOS device, that can be configured as a source follower to bias the high-voltage devices M_{CN} and M_{DN}. The second PMOS device M_{B2} can include a gate terminal coupled to the second input 410, a drain terminal coupled to the source terminal of the second low-voltage device M₂ at node NCMM, and a source terminal coupled to the gate terminal of the second cascode device M_{CN}. The second bias circuit can include or use an instance of the voltage source V_{B} between the second PMOS device M_{B2} and the gate terminal of the second cascode device M_{CN}, or can include an instance of the current source I_{B} coupled to the gate terminal of the second cascode device M_{CN}.

In the first example transconductance stage 400, the source or bulk terminals of the low-voltage input devices load the corresponding NCMP and NCMM nodes. This is in contrast with the second transconductance circuit 304 of FIG. 3. In the second transconductance circuit 304, source terminals of large LDMOS devices load the corresponding NCMP and NCMM nodes, thereby compromising bandwidth and increasing power consumption of the second transconductance circuit 304. In the first example transconductance stage 400 of FIG. 4A, however, the lower capacitive load at the NCMP and NCMM nodes provides lower power consumption and can help improve circuit bandwidth and high frequency performance. Furthermore, the physical size of the low-voltage devices (e.g., M₁, M_{D1}, M₂, M_{D2}) can be less than the physical size of the high-voltage devices (e.g., M_{CP}, M_{DP}, M_{CN}, M_{DN}), which in turn provides lower input capacitance at the first input 408 and the second input 410.

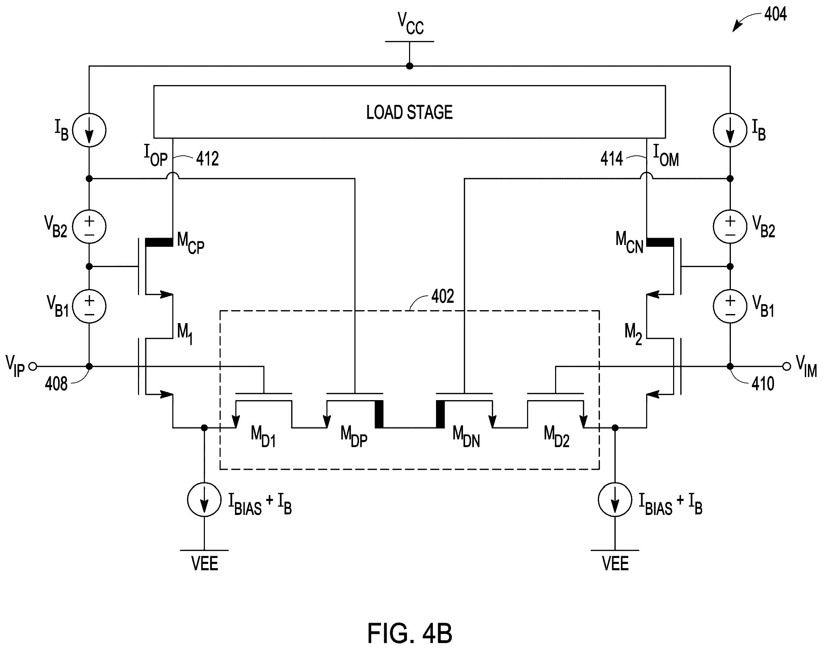

FIG. 4B illustrates generally a second example transconductance stage 404. The second example transconductance stage 404 can include the second degeneration stage circuit 402 and can be substantially the same as the first example transconductance stage 400 but with other circuitry configured to establish bias conditions for the high-voltage devices.

In the example of FIG. 4B, a third bias circuit can include or use a first voltage source V_{B1} between the first input 408 and the gate terminal of the first cascode device M_{CP}, and can include or use a second voltage source V_{B2} between the gate terminals of the first and second cascode devices M_{CP} and M_{DP}. That is, different bias voltages can optionally be provided at the gate terminals of the cascode devices. In an example, the third bias circuit can include a current source I_{B} coupled to the gate terminal of the first cascode device M_{CP}. In an example, the first and second voltage sources V_{B1} and V_{B2} can be implemented using, for example, a resistor or low-voltage diode, Zener diode, or a diode-connected low-voltage MOS device. The second example transconductance stage 404 can include a fourth bias circuit that is configured symmetrically with the third bias circuit. For example, the fourth bias circuit can include instances of the first and second voltage sources V_{B1} and V_{B2} and/or the current source I_{B}.

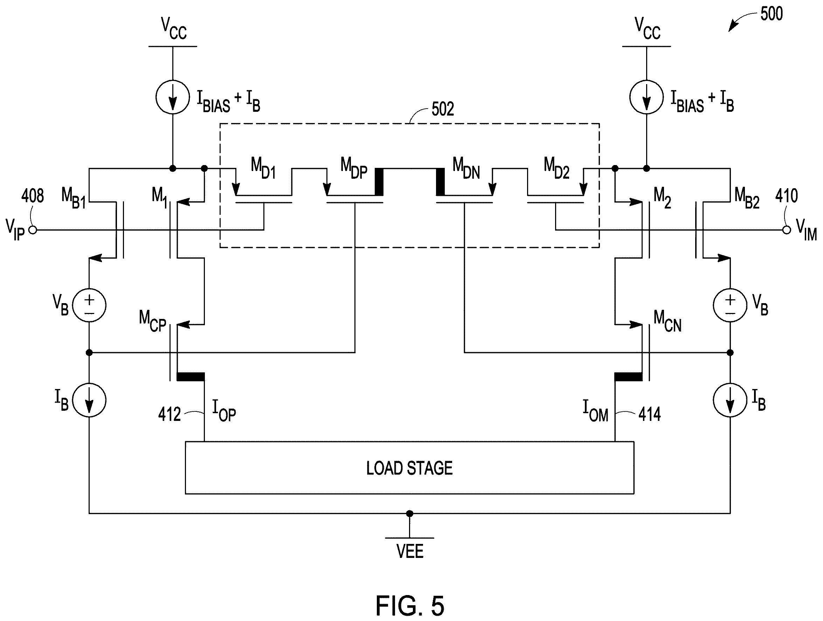

FIG. 4A and FIG. 4B illustrate generally NMOS-based implementations of different transconductance stages such as for an input stage of an amplifier or comparator. In an example, PMOS-based implementations can similarly be used. FIG. 5 illustrates generally an example PMOS transconductance stage 500. Similarly to the first example transconductance stage 400 and the second example transconductance stage 404, the example PMOS transconductance stage 500 includes low-voltage input devices M₁ and M₂ coupled to the first input 408 and the second input 410 respectively and arranged as a differential pair. The first and second low-voltage input devices are coupled to, and protected by, corresponding respective high-voltage cascode devices M_{CP} and M_{CN}. The example PMOS transconductance stage 500 can include or use a PMOS degeneration stage circuit 502. The PMOS degeneration stage circuit 502 can comprise a pair of low-voltage devices (e.g., M_{D1} and M_{D2}) and corresponding respective protection or cascode devices (e.g., M_{DP} and M_{DN}). Each of the high-voltage cascode devices can be a PMOS-based LDMOS device that uses a p-type channel. The example of the example PMOS transconductance stage 500 includes bias circuitry for the high-voltage devices that includes NMOS devices M_{B1} and M_{B2}, voltage source V_{B} and current source I_{B}. Other bias circuitry or bias configurations can similarly be used.

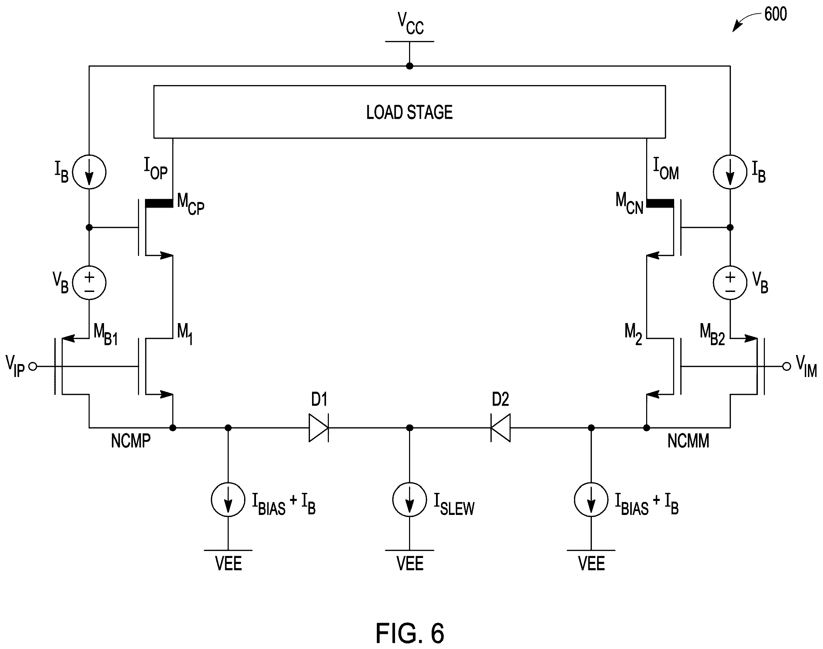

FIG. 6 illustrates generally a third example transconductance stage 600. The third example transconductance stage 600 includes the first and second low-voltage input devices M₁ and M₂ coupled to respective high-voltage cascode devices or protection devices M_{CP} and M_{CN}. In the third example transconductance stage 600, the low-voltage input devices M₁ and M₂ can include MOS transistors and the high-voltage devices M_{CP} and M_{CN} can include LDMOS devices. Bias circuitry can be provided to selectively bias the protection devices M_{CP} and M_{CN}. For example, the bias circuitry can include a low-voltage PMOS device M_{B1}/M_{B2}, a voltage source V_{B} and/or a current source I_{B}, as similarly discussed above in the example of FIG. 4A. The current source can bias the source follower device M_{CP}, and the voltage source can be used to ensure that the input devices M₁ and M₂ operate in the saturation region. A minimum bias current, I_{BIAS}, flows through the input devices M₁ and M₂. When the input voltage is balanced, bias current I_{SLEW} is shared equally between the positive and negative branches (i.e., left and right sides as illustrated) of the third example transconductance stage 600. Depending on the input signal polarity at the input devices, I_{SLEW} is steered between the branches.

The third example transconductance stage 600 can include protection diodes at the source terminals of the low-voltage input devices M₁ and M₂. For example, diodes D1 and D2 can be provided in series, in a back-to-back configuration between the source terminals. In an example, the diodes D1 and D2 can be used in place of degeneration transistors (see, e.g., the devices comprising the second degeneration stage circuit 402 in the first example transconductance stage 400 of FIG. 4A). In an example, the diodes are high-voltage devices, a body diode of LDMOS devices, or can comprise diode-connected LDMOS devices.

In the third example transconductance stage 600, an on-impedance of the diodes D1 and D2 can be relatively low compared to degeneration transistors. A total degeneration impedance can thus be small, and a relatively higher transconductance can be realized using approximately the same bias current as is used by the first example transconductance stage 400. However, diode-based implementations can have higher capacitance at the source terminals of the input devices, and diode switching time (or reverse recovery time) can be relatively long, which can impact power and bandwidth characteristics of the third example transconductance stage 600. Furthermore, high-voltage diodes may not be available in some fabrication processes.

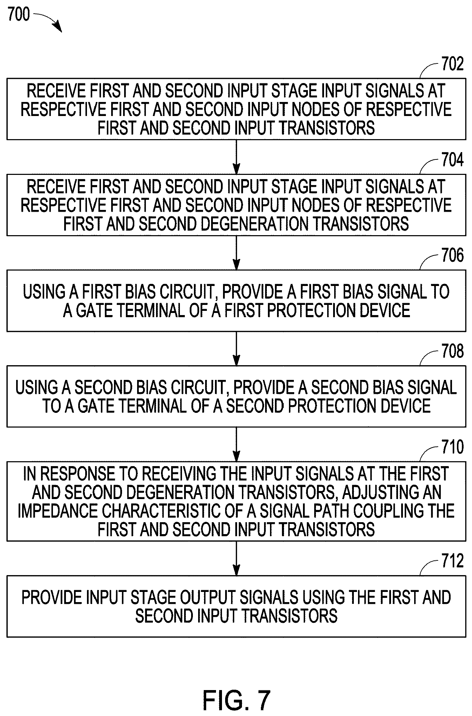

FIG. 7 illustrates generally an example of a first method 700 that includes operating an input stage with improved gain and bandwidth characteristics. In an example, the input stage can comprise a portion of a comparator circuit, such as can be used in a pin driver or other automated test equipment (ATE), among other things.

At operation 702, the first method 700 includes receiving first and second input stage input signals at respective first and second input nodes of respective first and second input transistors. In an example, the input transistors comprise respective low-voltage core MOS transistor devices arranged as a differential pair. At operation 704, the first method 700 includes receiving the first and second input stage input signals at respective first and second input nodes of respective first and second degeneration transistors (M_{D1}/M_{D2}). In an example, the degeneration transistors comprise respective MOS devices.

At operation 706, the first method 700 includes using a first bias circuit, providing a first bias signal to a gate terminal of a first protection device. At operation 708, the first method 700 includes using a second bias circuit, providing a second bias signal to a gate terminal of a second protection device. In an example, the first and second protection devices comprise respective LDMOS devices. In an example, the first degeneration transistor and the first protection device can comprise a first cascode circuit, and the second degeneration transistor and the second protection device can comprise a second cascode circuit. The first and second cascode circuits can be coupled in series between the first and second input transistors to provide a degeneration stage circuit for the input stage. For example, the first and second cascode circuits can provide a protected, variable-impedance path that selectively couples the first and second input transistors.

In an example, each of the bias circuits comprises one or more of an amplifier (e.g., a transistor, such as can comprise a MOS or LDMOS device), a voltage source, or a current source. In an example, the first method 700 can include receiving the first and second input stage input signals at gate terminals of transistors that comprise the bias circuits. In various examples, gate terminals of the respective degeneration transistors can be coupled in parallel with the respective transistors of the bias circuits.

In an example, additionally or alternatively to using the first and second bias circuits, one or more isolation circuits can be provided to help isolate control of the degeneration transistors and/or protection devices from the input transistors. The isolation circuits can include, for example, a voltage source configured to drive one or more of the degeneration transistors and the protection devices. In an example, the bias circuitry for the high-voltage cascode devices can comprise low-voltage MOS devices and/or high-voltage LDMOS devices.

At operation 710, the first method 700 includes, in response to receiving the input signals at the first and second degeneration transistors, adjusting an impedance characteristic of a signal path coupling the first and second input transistors. In an example, the signal path includes the first and second degeneration transistors and their respective protection devices arranged in series. When the first and second bias signals exceed a threshold voltage value, the signal path coupling the first and second input transistors has a lower impedance characteristic, and when at least one of the first and second bias signals does not exceed the threshold voltage value, the signal path coupling the first and second input transistors has a higher impedance characteristic.

At operation 712, the first method 700 includes providing a first output signal of the input stage using a first output terminal of the first input transistor and providing a second output signal of the input stage using a second output terminal of the second input transistor. In an example, operation 712 includes processing the output signals using other protection devices that respectively correspond to the first input transistor and the second input transistor. For example, the other protection devices can be one or more other transistors (e.g., LDMOS transistors) provided in cascode with the first and second input transistors.

Various embodiments of transconductance circuits with degeneration stages as described herein may be implemented in any kind of system where conversion of voltage to current may be used. One example of such a system was shown in FIG. 2 where the transconductance circuit comprises part of an amplification stage, and can further include a load as illustrated in any of FIG. 2 through FIG. 6. The transconductance circuit can optionally be followed by one or more other gain stages. In some embodiments, the transconductance circuit can comprise a portion of a comparator or an amplifier.

In some examples, the transconductance circuit can be included in a radio system, e.g., in an RF transmitter of a cellular wireless communication system. In still other examples, the transconductance circuit can be used in variable gain-amplifiers, continuous-time filters, delta-sigma modulators, or data converters.

Moreover, various embodiments of transconductance circuits with degeneration transistors can be implemented in various electronic devices. Examples of the electronic devices can include, but are not limited to, electronic products, parts of electronic products such as integrated circuits, vehicular electronics such as automotive electronics, etc. Further, the electronic devices can include unfinished or other intermediate products.

Various aspects of the present disclosure can help provide a solution to the amplifier input stage gain and bandwidth-related problems identified herein, as set forth in the following Examples.

Example 1 is an input stage circuit comprising: a first input transistor (e.g., M₁) configured to receive a first portion of a differential input signal at a first gate terminal and provide a first portion of an output signal at a first drain terminal of the first input transistor; a second input transistor (e.g., M₂) configured to receive a second portion of the differential input signal at a second gate terminal and provide a second portion of the output signal at a second drain terminal of the second input transistor; and a degeneration stage circuit configured to control an impedance of a signal path that couples source terminals of the first and second input transistors, wherein the degeneration stage circuit includes, first and second cascode circuits (e.g., M_{D1}/M_{DP}, and M_{D2}/M_{DN}) coupled in series, wherein each of the cascode circuits comprises first and second transistor devices with respective different breakdown voltage characteristics.

In Example 2, the subject matter of Example 1 optionally includes the first and second input transistors comprise respective low-voltage core MOS transistor devices. In an example, the low-voltage core MOS transistor devices are other than LDMOS devices.

In Example 3, the subject matter of Example 2 optionally includes the first transistor device of each of the first and second cascode circuits comprises a respective low-voltage core MOS transistor device. In an example, the low-voltage core MOS transistor devices are other than LDMOS devices.

In Example 4, the subject matter of Example 3 optionally includes the second transistor device of each of the first and second cascode circuits comprises a respective LDMOS device.

In Example 5, the subject matter of any one or more of Examples 2-4 optionally includes the second transistor device (e.g., M_{DP} or M_{DN}) of each of the first and second cascode circuits comprises a respective LDMOS device.

In Example 6, the subject matter of any one or more of Examples 1-5 optionally includes a first protection transistor (e.g., M_{CP}) coupled to the first drain terminal of the first input transistor and a second protection transistor (e.g., M_{CN}) coupled to the second drain terminal of the second input transistor. In Example 6, the first protection transistor can have a higher breakdown voltage characteristic than the first input transistor, and the second protection transistor can have a higher breakdown voltage characteristic than the second input transistor.

In Example 7, the subject matter of Example 6 optionally includes the first and second protection transistors comprise respective LDMOS transistors, and the first and second input transistors comprise respective MOS transistors that are other than LDMOS transistors.

In Example 8, the subject matter of any one or more of Examples 6-7 optionally includes a bias generator circuit configured to provide respective voltage bias signals to the first and second protection transistors and to the second transistor devices of each of the first and second cascode circuits.

In Example 9, the subject matter of Example 8 optionally includes the bias generator circuit comprises a third input transistor (e.g., M_{B1}), wherein a gate terminal of the third input transistor is coupled to the first gate terminal of the first input transistor, and wherein a drain terminal of the third input transistor is coupled to a source terminal of the first input transistor.

In Example 10, the subject matter of any one or more of Examples 8-9 optionally includes the bias generator circuit comprises a first voltage source (e.g., V_{B1}) configured to bias a gate terminal of the first protection transistor (M_{CP}) and a second voltage source (V_{B2}) configured to bias a gate terminal of the second transistor device (M_{DP}) of the first cascode circuit.

In Example 11, the subject matter of any one or more of Examples 1-10 optionally includes, when the first and second portions of the differential input signal are substantially equal in magnitude, the first and second cascode circuits provide a low-impedance signal path between the source terminals of the first and second input transistors.

In Example 12, the subject matter of any one or more of Examples 1-11 optionally includes, when the first and second portions of the differential input signal are not substantially equal in magnitude, at least one of the first and second cascode circuits is configured to provide a high-impedance signal path in the degeneration stage circuit.

In Example 13, the subject matter of any one or more of Examples 1-12 optionally includes a first tail current source coupled to a source terminal of the first input transistor and to the first cascode circuit, and a second tail current source coupled to a source terminal of the second input transistor and to the second cascode circuit.

In Example 14, the subject matter of Example 13 optionally includes respective tail current signals from the first and second tail current sources are configured to maintain operation of the first and second input transistors in their respective saturation regions.

Example 15 is a system comprising: a first portion of a transconductance circuit including: a first degeneration transistor (e.g., M_{D1}) coupled to a first protection device (M_{DP}); a first input transistor (e.g., M₁) configured to receive a first portion of a differential input signal at a first input node and, in response, provide a first output current at a first output node, wherein a gate terminal of the first input transistor is coupled to a gate terminal of the first degeneration transistor; and a first bias circuit configured to provide a bias signal to the first protection device (e.g., M_{DP}). Example 15 can include a second portion of the transconductance circuit including: a second degeneration transistor (e.g., M_{D2}) coupled to a second protection device (e.g., M_{DN}), wherein the second protection device is coupled to the first protection device (e.g., M_{DP}); a second input transistor (e.g., M₂) configured to receive a second portion of the differential input signal at a second input node and, in response, provide a second output current at a second output node, wherein a gate terminal of the second input transistor is coupled to a gate terminal of the second degeneration transistor; and a second bias circuit configured to provide a second bias signal to the second protection device (e.g., M_{DN}).

In Example 16, the subject matter of Example 15 optionally includes the first portion of the transconductance circuit comprising a first cascode transistor (e.g., M_{CP}) coupled between the first input transistor and a first differential output node; and the second portion of the transconductance circuit comprising a second cascode transistor (e.g., M_{CN}) coupled between the second input transistor and a second differential output node.

In Example 17, the subject matter of Example 16 optionally includes the first and second cascode transistors comprise LDMOS transistors, and the first and second protection devices comprise LDMOS transistors.

In Example 18, the subject matter of Example 17 optionally includes the first and second input transistors comprise low-voltage MOS transistors, and the first and second degeneration transistors comprise low-voltage MOS transistors.

Example 19 is a method for controlling gain and bandwidth characteristics of an input stage circuit, the method comprising: receiving first and second input stage input signals at respective first and second input nodes of respective first and second input transistors (e.g., comprising low-voltage MOS devices); receiving the first and second input stage input signals at respective first and second input nodes of respective first and second degeneration transistors (e.g., comprising low-voltage MOS devices); using a first bias circuit, providing a first bias signal to a gate terminal of a first protection device (e.g., a high-voltage MOS device); using a second bias circuit, providing a second bias signal to a gate terminal of a second protection device (e.g., a high-voltage MOS device); in response to receiving the input signals at the first and second degeneration transistors, adjusting an impedance characteristic of a signal path coupling the first and second input transistors; providing a first input stage output signal using a first output terminal of the first protection device, wherein the first protection device is provided in cascode with the first input transistor; and providing a second input stage output signal using a second output terminal of the second protection device, wherein the second protection device is provided in cascode with the second input transistor.

In Example 20, the subject matter of Example 19 optionally includes, using the first bias circuit, providing a bias signal to a gate terminal of a third protection device (e.g., a high-voltage MOS device), wherein the third protection device is provided in cascode with the first degeneration transistor; and using the second bias circuit, providing a bias signal to a gate terminal of a fourth protection device (e.g., a high-voltage MOS device), wherein the fourth protection device is provided in cascode with the second degeneration transistor.

Each of these non-limiting Examples can stand on its own, or can be combined in various permutations or combinations with one or more of the other Examples or features discussed elsewhere herein.

This detailed description includes references to the accompanying drawings, which form a part of the detailed description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. The present inventors contemplate examples using any combination or permutation of those elements shown or described (or one or more aspects thereof), either with respect to a particular example (or one or more aspects thereof), or with respect to other examples (or one or more aspects thereof) shown or described herein.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein."

In the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects. The terms "MOS" and "MOSFET" are used herein, consistent with usage in the art, to include FETs that comprise various materials; for example, the devices need not include a metal gate and need not include an oxide as a gate dielectric, but can include or use other materials instead.

Method examples described herein can be machine or computer-implemented at least in part. Some examples can include a computer-readable medium or machine-readable medium encoded with instructions operable to configure an electronic device to perform methods or circuit operations or circuit configuration instructions as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. An input stage circuit comprising:
a first input transistor configured to receive a first portion of a differential input signal at a first gate terminal and provide a first portion of an output signal at a first drain terminal of the first input transistor;
a second input transistor configured to receive a second portion of the differential input signal at a second gate terminal and provide a second portion of the output signal at a second drain terminal of the second input transistor; and
a degeneration stage circuit configured to control an impedance of a signal path that couples source terminals of the first and second input transistors, wherein the degeneration stage circuit includes first and second cascode circuits coupled in series, wherein each of the cascode circuits comprises first and second transistor devices with respective different breakdown voltage characteristics.

2. The input stage circuit of claim 1, wherein the first and second input transistors comprise respective low-voltage core MOS transistor devices.

3. The input stage circuit of claim 2, wherein the first transistor device of each of the first and second cascode circuits comprises a respective low-voltage core MOS transistor device.

4. The input stage circuit of claims 2 or 3, wherein the second transistor device of each of the first and second cascode circuits comprises a respective LDMOS device.

5. The input stage circuit of any of claims 1 to 4, comprising:
a first protection transistor coupled to the first drain terminal of the first input transistor; and
a second protection transistor coupled to the second drain terminal of the second input transistor;
wherein the first protection transistor has a higher breakdown voltage characteristic than the first input transistor, and the second protection transistor has a higher breakdown voltage characteristic than the second input transistor.

6. The input stage circuit of claim 5, wherein the first and second protection transistors comprise respective LDMOS transistors, and wherein the first and second input transistors comprise respective MOS transistors that are other than LDMOS transistors.

7. The input stage circuit of claim 6, comprising a bias generator circuit configured to provide respective voltage bias signals to the first and second protection transistors and to the second transistor devices of each of the first and second cascode circuits.

8. The input stage circuit of claim 7, wherein the bias generator circuit comprises a third input transistor, wherein a gate terminal of the third input transistor is coupled to the first gate terminal of the first input transistor, and wherein a drain terminal of the third input transistor is coupled to a source terminal of the first input transistor.

9. The input stage circuit of claims 7 or 8, wherein the bias generator circuit comprises a first voltage source configured to bias a gate terminal of the first protection transistor and a second voltage source configured to bias a gate terminal of the second transistor device of the first cascode circuit.

10. The input stage circuit of any of claims 1 to 9, wherein:
i) when the first and second portions of the differential input signal are substantially equal in magnitude, the first and second cascode circuits provide a low-impedance signal path between the source terminals of the first and second input transistors; and/or
ii) when the first and second portions of the differential input signal are not substantially equal in magnitude, at least one of the first and second cascode circuits is configured to provide a high-impedance signal path in the degeneration stage circuit.

11. The input stage circuit of any of claims 1 to 10, comprising:
a first tail current source coupled to a source terminal of the first input transistor and to the first cascode circuit; and
a second tail current source coupled to a source terminal of the second input transistor and to the second cascode circuit;
wherein optionally respective tail current signals from the first and second tail current sources are configured to maintain operation of the first and second input transistors in their respective saturation regions.

12. A system comprising:
a first portion of a transconductance circuit including:
a first degeneration transistor coupled to a first protection device;
a first input transistor configured to receive a first portion of a differential input signal at a first input node and, in response, provide a first output current at a first output node, wherein a gate terminal of the first input transistor is coupled to a gate terminal of the first degeneration transistor; and
a first bias circuit configured to provide a bias signal to the first protection device; and
a second portion of the transconductance circuit including:
a second degeneration transistor coupled to a second protection device, wherein the second protection device is coupled to the first protection device;
a second input transistor configured to receive a second portion of the differential input signal at a second input node and, in response, provide a second output current at a second output node, wherein a gate terminal of the second input transistor is coupled to a gate terminal of the second degeneration transistor; and
a second bias circuit configured to provide a second bias signal to the second protection device.

13. The system of claim 12, the first portion of the transconductance circuit comprising a first cascode transistor coupled between the first input transistor and a first differential output node; and
the second portion of the transconductance circuit comprising a second cascode transistor coupled between the second input transistor and a second differential output node;
wherein optionally: the first and second cascode transistors comprise LDMOS transistors, and wherein the first and second protection devices comprise LDMOS transistors; and
wherein further optionally: the first and second input transistors comprise low-voltage MOS transistors, and wherein the first and second degeneration transistors comprise low-voltage MOS transistors.

14. A method for controlling gain and bandwidth characteristics of an input stage circuit, the method comprising:
receiving first and second input stage input signals at respective first and second input nodes of respective first and second input transistors;
receiving the first and second input stage input signals at respective first and second input nodes of respective first and second degeneration transistors;
using a first bias circuit, providing a first bias signal to a gate terminal of a first protection device;
using a second bias circuit, providing a second bias signal to a gate terminal of a second protection device;
in response to receiving the input signals at the first and second degeneration transistors, adjusting an impedance characteristic of a signal path coupling the first and second input transistors;
providing a first input stage output signal using a first output terminal of the first protection device, wherein the first protection device is provided in cascode with the first input transistor; and
providing a second input stage output signal using a second output terminal of the second protection device, wherein the second protection device is provided in cascode with the second input transistor.

15. The method of claim 14, comprising:
using the first bias circuit, providing a bias signal to a gate terminal of a third protection device, wherein the third protection device is provided in cascode with the first degeneration transistor; and
using the second bias circuit, providing a bias signal to a gate terminal of a fourth protection device, wherein the fourth protection device is provided in cascode with the second degeneration transistor.
